# EUROPEAN PATENT APPLICATION

(11) **EP 1 396 557 A1**
(43) Date of publication of application: **10.03.2004**
(21) Application number: 03255603.7
(22) Date of filing: 09.09.2003
(51) Int. Cl.: C23F 1/18, C23G 1/10, H05K 3/06

(54) **Metal cleaning composition and process**

(30) Priority: 09.09.2002 US 409239 P
(71) Applicant: Shipley Co. L.L.C., Marlborough, MA 01752 (US)
(72) Inventor: Carter, John G., Ithaca New York 14850 (US); Fellman, Jack D., New Boston NH 03070 (US); Knop, Jack M., Owego New York 13827 (US); Bayes, Martin W., Hopkinton Massachusetts 01748 (US)
(74) Representative: Kent, Venetia Katherine

(57) **Abstract**

A composition composed of a persulfate, boric acid, a fluorine containing acid and an inorganic acid. Adjuvants also may be included in the composition. The composition may be employed as a microetch solution in the fabrication of microclectronic packages.

## Description

The present invention is directed to an improved cleaning composition for metal. More specifically, the present invention is directed to an improved cleaning composition for metal which improves metal saturation and crystallisation during microetching.

Many chemical etching processes for metals, such as copper, on microelectronic substrates are performed with either copper or ferric chlorides, chromium salts, alkaline-ammonia, hydrogen peroxide-sulfuric acid or nitric acid compositions. Such compositions have certain limitations and disadvantages as described below.

Metal etchants, in particular the chromium salts, create a deleterious environmental impact. Chromium salts also are known to be carcinogenic to humans and their use and disposal are problematic.

Nitric acid, either alone or in combination with sulfuric or copper nitrate, has been reported by Battey (U.S. 4,695,348) to be useful for etching copper in circuit boards. However, nitrogenous oxide gas is a byproduct of this process. Also, the process provides anisotropic etching only for certain orientations of copper (i.e., the top surface of the copper crystal structure must have a Miller index of (111) and (200) orientation). This requires first sputtering copper and then electrodepositing more copper. In lieu of sputtered copper, evaporative deposition or electroless deposition also is possible.

Alkaline-ammonia compositions are used commercially because they are relatively fast, have substantial copper-carrying capacity and are reasonably tolerant of some metal resists and some dry film resists. However, these same compositions have poor selectivity for copper versus other metals and alloys. Significant process control is required to achieve acceptable selectivity. Such compositions may not work well with fine line copper geometries. Furthermore, the dissolved copper is difficult to recover. Additionally, fumes from ammonia present the worker exposure concerns.

Hydrogen peroxide-sulfuric acid compositions used in copper etching processes are very clean to operate and may be recycled. However, such compositions have relatively slow etching rates and require substantial cooling for stability control due to the autodecomposition reaction of the hydrogen peroxide. Additionally, both the performance of the process and the decomposition of the hydrogen peroxide are sensitive to trace impurities via homo- or hetero-catalysis. Stabilizers are necessary for peak performance but these are metal specific. Brasch (U.S. 4,378,270) teaches phenol-sulfonic acid for copper containing solutions. It also is known from Alderuccio et al. (U.S. 3,269,881) that these compositions are adversely affected by chloride or bromide ion at levels of 2 mg/Liter, causing reduced etch rates. Elias (U.S. 4,130,455) teaches that the addition of sodium or potassium thiosulfate can counteract this effect.

Use of the above additives does not address the basic problem of the catalytic decomposition of the peroxide discussed hereinbefore. This decomposition has two important implications: firstly, the depletion of the peroxide in the etchant solution reduces the etchant rate; and secondly, there is potential for uncontrolled decomposition of large volumes of high temperature solutions, generating high concentrations of oxygen and increasing the safety risks therefrom. Because decomposition of the peroxide is accelerated at elevated temperatures, processing temperatures must be kept low. This adversely affects the rate of the etching process and exacerbates the already low copper-carrying capacity of the peroxide-sulfuric acid composition. Finally, the process generates voluminous quantities of copper sulfate, which are difficult to reclaim or dispose of. Copper may be electroplated out from the copper sulfate. Typically, however, this copper does not deposit as an adherent homogeneous ingot deposit, but rather comes out as a powder which sluffs off and makes recovery difficult. Brasch describes the use of phosphoric acid to assist in producing smooth adherent copper deposits on a cathodic surface, but this is at the expense of a slower etch rate.

Etch compositions containing persulfate without hydrogen peroxide eliminate the problems associated with hydrogen peroxide etch solutions. Etch solutions of potassium monopersulfate are prepared by dissolving a desired amount of the salt in a 1% to 3% by volume sulfuric acid solution. The solution is then put into production for lightly etching copper as part of the surface process prior to a chemical process, such as plating, oxide coating, or solder coating. As the panels containing copper circuits are cleaned in the etch bath, the copper is lightly etched, and the surface layers of copper are removed and dissolve in the bath as copper sulfate salts. The process of cleaning is called a microetch due to the removal of surface layers of copper. Amounts of copper etched away in the surface preparation step are from 10 to 60 microinches, depending on the particular chemical process to follow. As work is processed through the bath, the copper concentration continues to increase and the concentration of the persulfate solution decreases. Process control is done by a measurement of the copper etch rate by a weight-loss method. The persulfate solution concentration is determined by a redox titration called the available oxygen concentration (AOC) because the active compound, potassium monopersulfate, is an oxidizing agent that contains oxygen. Replenishment of the potassium monopersulfate solution may be made according to the results of the analysis for AOC taking into consideration the etch rate and copper concentration. When the copper concentration exceeds 12 to 15 grams/Liter in the bath, it is transferred to a waste treatment tank to remove the copper and a new bath is prepared. While the persulfate etch overcomes some of the problems associated with the hydrogen peroxide-sulfuric acid compositons described above, there is still a need for improvement in the microetch processes which employ persulfate.

A persulfate microetch solution which provides for more metal solubility, such as improved copper solubility, in the microetch process may increase the metal parts microetched or cleaned during fabrication of microelectronic packages. A particularly suitable persulfate etch solution for copper is one which has a fluorine containing acid. However, a number of persulfate solutions which have a fluorine containing acid suffer from formation and precipitation of an insoluble compound. The insoluble compound may be composed of the elements potassium, fluorine and silicon such as a mixture of potassium fluoroborate and potassium fluorosilicate. However, the exact composition of the precipitate is yet uncertain. Nevertheless, the insoluble compound may result in contamination of substrates which are being microetched as well as leading to contamination of microelectronic products. Accordingly, there is a need for an improved persulfate microetch composition.

### Summary of the Invention

The present invention is directed to a composition that includes a persulfate, fluorine containing acids, boric acid or salts of boric acid. The composition may also include one or more additional inorganic acids or salts thereof, and adjuvants to assist in cleaning a metal. The present invention also is directed to a method of making the composition. The composition may be employed as a microetch solution for cleaning metal such as in the manufacture of printed circuit or wiring boards. Thus, the present invention also is directed to a method of cleaning or microetching a metal. The persulfate composition of the present invention is highly suitable for microethcing metal in the manufacture of printed circuit boards and wiring. Accordingly, the present invention also is directed to a method of making printed circuit and wiring boards.

Advantageously, the persulfate composition of the present invention increases the copper saturation and crystallization concentration in microetch solutions which results in higher yields of metal parts per liter of microetch solution. Accordingly, the persulfate compositions improve microetch efficiency. The persulfate compositions also have an increased useful life, and reduce the volume of spent microetch solutions or baths which are sent to waste treatment for chemical precipitation and disposal. Thus, the persulfate compositions are environmentally friendly. Further, the persulfate compositions make metal recycling/recovery processes of electrowinning more efficient due to the increased metal concentrations in microetching baths. Another advantage of the persulfate compositions of the present invention is that insoluble precipitates do not form in the microetch solutions or baths. Such insoluble precipitates may contaminate microcomponents during the manufacture of printed circuit and wiring boards. Additionally, the insoluble precipitates must be sent to waste treatment to prevent contamination of the environment. Such insoluble precipitates undesirably add to the cost of manufacturing microelectronic packages.

### Detailed Description of the Invention

The present invention is directed to a composition that includes a persulfate, fluorine containing acids, boric acid or salts of boric acid. The composition may also include one or more additional inorganic acids or salts of inorganic acids, and adjuvants to assist in cleaning a metal. The composition may be employed as a cleaning composition for cleaning metal such as in the fabrication of microelectronic packages and the manufacture of printed circuit and wiring boards. While the composition of the present invention may be employed to clean various metals and metal alloys, the persulfate composition is highly suitable for cleaning copper and copper alloys. Cleaning within the scope of the present invention refers to microetching. The process of cleaning is called a microetch or microetching because application of the persulfate composition removes surface layers of a metal, such as copper, or a metal alloy. The amount of metal removed may vary depending on the metal being microetched and the particular chemical process which follows the microetch. Typically, the amount of copper microetched away with a persulfate compositon ranges from 5 to 80 microinches (2.54 centimeters/inch), more typically from 10 to 60 microinches. The persulfate compositions may be applied to a metal for microetching by any suitable method as discussed below. Typically the persulfate compositions are aqueous solutions.

The persulfate compositions have from 1.0% by weight to 35% by weight of a persulfate oxidizing agent, preferably from 10% by weight to 25% by weight of the composition. Any suitable source of persulfate may be employed to practice the present invention. Examples of sources of persulfate include, but are not limited to, alkali metal monopersulfate salts such as sodium and potassium monopersulfate. A preferred monopersulfate is potassium monopersulfate.

Persulfate compositions also contain boric acid or a salt of boric acid or a mixture of boric acid and a salt of boric acid. Boric acid or a salt of boric acid ranges from 0.1 % to 10% by weight of the persulfate composition, preferably from 1% to 5% by weight of the composition. Any suitable form of boric acid or salt of boric acid may be used to practice the present invention. Examples of suitable forms of boric acid include, but are not limited to, technical grade boric acid. Suitable salts of boric acid include, but are not limited to, alkali metal salts such as lithium, sodium and potassium salts.

Fluorine containing acids are employed in the persulfate compositions in amounts of from 0.1% by weight to 10% by weight, preferably from 1.0% to 5% by weight of the composition. Any suitable fluorine containing acid may be employed in the present invention. Examples of such fluorine containing acids include, but are not limited to, hydrofluoric acid, fluoroboric acid, fluorosilic acid or mixtures thereof. A preferred fluorine containing acid is fluoroboric acid.

Additional inorganic acids that may be employed in the compositions of the present invention include, but are not limited to, sulfuric acid, phosphoric acid, and phosphorous acid or mixtures thereof. Hydrochloric acid and nitric acid preferably are not employed to practice the present invention due to toxic byproducts such as nitrogen oxides and chlorine gas. The additional inorganic acids may be employed in ranges of from 0.5% by weight to 15% by weight of the composition, preferably from 5% to 10% by weight of the composition.

The persulfate composition also may contain optional adjuvants. Adjuvants such as surfactants and banking agents may have beneficial effects for the microetchant formulation. Surfactants are incorporated into the composition primarily to reduce adhesion of air or gas bubbles to the microetched surface of a metal. If this is not provided for, there is the possibility of creating irregularly-microetched surfaces due to the bubbles preventing fresh microetchant from contacting the metal surface. Typically surfactants may be anionic, cationic, nonionic or inner salt types. Anionic surfactants may contain phosphate, sulfate, sulfonate or sulfate groups attached to long chain alkyl or aryl moieties.

Cationic surfactants may be quaternary ammonium salts with a long chain alkyl or aryl moiety. Nonionic surfactants may be composed of long chain alkyl or aryl moieties possessing polyethylene oxy functionality. Inner salt surfactants contain both anionic and cationic functionalities that are equally balanced to create a charge-neutral material. The present invention may employ all types of surfactants described above.

Banking agents are employed to provide greater anisotropy during the microetching process. The greater the difference between vertical and lateral etching rates, the higher is the anisotropy of the process. Examples of suitable banking agents include, but are not limited to, benzotriazoles such as the unsubstituted benzotriazoles.

The amounts of optional adjuvants added to the persulfate microetch composition of the present invention may vary depending on the particular microetch process employed and the type of metal to be microetched. Typically adjuvants are employed in conventional amounts well known in the art. The remainder of the persulfate compositions of the present invention is water to bring the compositions to 100% by weight.

The persulfate compositions may be utilized over a wide pH range. Typically the persulfate composition may be utilized over a pH range of from less than 0 to 7.0, preferably from a pH of 2.0 to a pH of 5.0.

The components of the persulfate composition may be combined together by any suitable method to form an aqueous microetch composition or bath solution. Preferably, the additional inorganic acids are added to a persulfate composition after boric acid or a salt of boric acid has been added or solubilized in the persulfate composition. The procedure of adding or solubilizing boric acid or a salt of boric acid is most preferable when the acid employed is sulfuric acid. Some grades of boric acid or salts of boric acid present a solubility problem in the presence of some inorganic acids. Accordingly, adding an inorganic acid such as sulfuric acid, phosphoric acid, phosphorous acid, or mixtures thereof to a microetch solution separately from the other components of the solution is preferred.

While not being bound to theory, the addition of boric acid or a salt of boric acid to the persulfate composition unexpectedly prevents the formation of an undesirable insoluble precipitate in microetch solutions. The insoluble precipitate may cause contamination of metal which is being microetched and also may contaminate the microelectronic packages and printed circuit boards. The nature of the insoluble precipitate may be a salt of potassium, fluorine or silicon. The compositions of the present invention also increase copper saturation and crystallization concentration to greater than 40 grams/Liter in contrast to conventional persulfate microetches which have a lower copper saturation and crystallisation concentration of 10 to 15 grams/Liter. Accordingly, the persulfate compositions show an increase in copper saturation and crystallization of 2 to 3 times.

Other advantages of the compositions of the present invention include reduced volume of spent baths to be sent to waste treatment for chemical precipitation and disposal by a factor of 2 to 3; increases the useful life of a persulfate bath by a factor of 2 to 3; and makes the copper recycling/recovery process of electrowinning more efficient due to the significantly higher copper concentration in solution. Another advantage of the present invention is the reduced process operating cost by a factor of 2 to 3. Further, since less waste is produced by the microetching methods of the present invention, the present invention is environmentally friendly.

The microetchant process of the present invention may be performed at room temperature. Preferably, the microetchant process of the present invention is performed at temperatures of from 80 to 100° F (27 to 38° C). The persulfate composition may be applied to a metal by spraying, or immersion or any other suitable method known in the art.

The persulfate composition may be employed to etch many metals such as copper, copper in the presence of nickel, or nickel alloys, or overcoated with noble metals such as porous gold and palladium. The persulfate composition also may be employed to microetch solder (Sn/Pb).

The persulfate composition of the present invention may be employed in any method where microetching is employed. For example, the persulfate composition of the present invention may be employed in the manufacture of printed circuit or wiring boards as discussed below.

A copper-clad laminate is formed by taking a ½ oz copper foil and a dielectric substrate or support and placing them in direct contact and applying pressure. Examples of materials that may be used for the dielectric support include thermoplastic and thermosetting resins, ceramics, glass and composites of glass cloth reinforced or unreinforced thermoset resins, specifically phenolic resins such as ABS, polyimides, and polymeric vinyl chloride.

A photoresist material is applied by either hot roll lamination, vacuum lamination or spin coating techniques. The photoresist material may be either negative-working (i.e. the imaged areas are hardened and unimaged areas are developed to uncover the underlying copper foil) or positive-working (i.e. the imaged areas are softened and eventually developed to uncover the underlying copper foil). The photoresist material may be applied in liquid form from either an aqueous or solvent based formulation. Materials for positive-working photoresist may be based on phenol-aldehyde condensations as the binder resin and o-quinonediazide as the photoactive compound.

Imaging the photoresist is performed by using glass masters or film and exposing using electromagnetic radiation, preferably ultraviolet radiation in the spectral region of from 365 to 435 nanometers. Development of the unexposed areas (negative resist system) may be accomplished with organic solvents or aqueous solutions which dissolve the unhardened photoresist. Examples of such solvents include propylene carbonate, gamma butyrolactone, and various ester formulations. Aqueous solutions include sodium carbonate. Propylene carbonate developer is typically accomplished at from 20° to 30° C, for 3 to 5 minutes in a spray developer at 30 to 40 psi spray pressure. Sodium carbonate development is typically accomplished at 80° F (27° C), for 3 to 5 minutes in a spray developer at 15 to 25 psi spray pressure.

Nickel or a nickel alloy may be electroplated or electrolessly plated onto the uncovered copper surfaces that are formed during the development of the imaged photoresist.

The remaining photoresist, having been hardened by ultraviolet exposure as described above, is stripped from the copper layer. Solvent strip solvents may include propylene carbonate and benzyl alcohol. A preferred aqueous solvent is sodium hydroxide. Solvent stripping in propylene carbonate may be accomplished at 90° C to 105° C for 5 to 8 minutes in a spray stripper at 50 to 60 psi spray pressure. Aqueous stripping may be accomplished at 135° F to 145° F (57° C to 63° C) for 5 to 8 minutes in a spray stripper at 20 to 30 psi spray pressure.

The unplated copper is microetched leaving any nickel-plated copper circuit patterns. The unplated copper is microetched with an aqueous microetch solution of potassium monopersulfate in sulfuric acid with fluoroboric acid and boric acid. Microetching may be performed in a spray etcher at 85° F to 95° F (29° C to 35°C) with a 20-30 psi spray pressure. The microetching may also be performed by immersion. The microetch rate is greater than 0.001 inches per minute (2.54 centimeters/inch).

The following examples are intended to illustrate the present invention but are not intended to limit the scope of the invention.

### Example 1

A cleaning bath for copper is prepared by dissolving potassium monopersulfate in a solution of sulfuric, boric and fluoroboric acids.

| Water | To volume |
|---|---|
| Potassium monopersulfate | 10 to 220 grams/Liter |
| Sulfuric acid 96% by weight | 2 to 3% by volume |
| Boric acid (technical grade) | 3 grams/Liter |
| Fluoroboric acid 48% by weight | 2,5 mls/Liter |

Makeup Procedure for 100 U.S. Gallons (0.2642 U.S. gallons/Liter)
1. About 90 U.S. gallons of water are added to a mixing tank or to a process tank.
2. Sulfuric acid, 2-3 U.S. gallons, is added to the water and mixed well.
3. Potassium monopersulfate, 100 pounds (453.6 grams/pound), is added and mixed well.
4. Boric Acid salts, 2.5 pounds, are added and mixed to dissolve.
5. fluoroboric acid, 946 milliliters, are added and the bath is uniformally mixed.

| Makeup Procedure with Additive Concentrate | | |
|---|---|---|
| a. | Sulfuric acid 50% by weight | 950 milliliters/Liter |
| b. | Boric acid | 60 grams/Liter |
| c. | Fluoroboric acid 48% by weight | 50 milliliters/Liter |

Makeup Procedure for 100 U.S. Gallons using Additive Concentrate
1. Add about 95 U.S. gallons of water to a mixing tank or to a process tank,
2. Add 5 U.S. gallons of the liquid additive concentrate and mix to form a uniform solution.
3. Add 100 pounds of potassium monopersulfate and mix to dissolve.

In an alternative method of formulating the microetch solution described above, a concentrate composed of 30.0-50.0 grams/Liter of boric acid and 35.0-55.0 grams/Liter of fluoroboric acid is prepared without sulfuric acid. The sulfuric acid may be added separately to the microetch solution apart from the concentrate. The concentrate containing the boric acid and fluoroboric acid may be employed in the microetch solution at 6.5% to 8.5% by volume.

### Example 2

A copper cleaning bath is prepared in a 100 U.S. gallon tank by dissolving 2.5 U.S. gallons of sulfuric acid 96% by weight in 100 U.S. gallons of water. 100 pounds (453.6 grams/pound) of potassium monopersulfate are added and dissolved with mixing. The bath is used in a cleaning process to prepare copper circuits on a panel for the application of solder in a hot air solder leveling process. Panels are processed through the bath and through the HASL machine. As the copper concentration increases in the bath from copper removal from circuits to the range of 12-15 grams/Liter, blue crystals of copper salts may be seen on the parts of the HASL machine where solution evaporates leaving behind dry salts. At this time, rinsing of the cleaned parts becomes more difficult due to the salt formation, and the bath must be pumped out and treated to remove and recover the copper. A new bath is made and the cycle is repeated. In this example, 8,000 square-feet of copper containing panels are processed through the cleaning bath before the bath is dumped.

### Example 3

A cleaning bath is prepared in a 100 U.S. gallon tank by the addition of 95 U.S. gallons of water and 5 U.S. gallons of the liquid additive concentrate described in Example 1 above followed by dissolving 100 pounds of potassium monopersulfate. The bath is used in a process for cleaning copper circuits prior to the application of solder in the HASL process of Example 2. Panels are processed through the copper cleaner and the HASL process and observations are made for the formation of copper salts above the level of the bath. The copper concentration is more than 40 grams/Liter before the dark blue solution began to form blue salts around the level of the bath. This corresponds to 24,000 square-feet of copper-containing panels or more than 3 times the yield of Example 2 before the bath is dumped, treated for disposal and the copper recovered. The operating cost of Example 3 is about 1/3 that of the process in Example 2. Thus, the persulfate composition of the present invention as disclosed in Example 1 is an improved persulfate microetch solution.

## Claims

1. A composition comprising a persulfate, a fluorine containing acid, and boric acid or a salt of boric acid or mixtures thereof.

2. The composition of claim 1, wherein the persulfate comprises sodium monopersulfate, potassium monopersulfate, or mixtures thererof.

3. The composition of claim 1, wherein the fluorine containing acid comprises hydrofluoric acid, fluoroboric acid, fluorosilic acid, or mixtures thereof.

4. The composition of claim 1, wherein the salts of boric acid comprise lithium, sodium, potassium salts of boric acid, or mixtures thereof.

5. The composition of claim 1, further comprising an additional inorganic acid.

6. A method of preparing a composition comprising:
a) providing an aqueous solution of a persulfate;
b) mixing a concentrate comprising boric acid or a salt of boric acid and a fluoride containing acid with the aqueous solution of the persulfate to form a first mixture; and
c) mixing an additional inorganic acid with the first mixture to form a stable second mixture.

7. The method of claim 6, wherein the additional inorganic acid is sulfuric acid.

8. A method of microetching a metal comprsing: contacting a surface of a metal with a microetch solution comprising a persulfate, boric acid or a salt of boric acid, a fluoride containing acid and an additional inorganic acid to remove a portion of the surface of the metal.

9. The method of claim 8, wherein the metal comprises copper.

10. The method of claim 9, wherein the copper saturation and crystallization concentration in the microetch solution is greater than 40 grams/Liter.
